# EUROPEAN PATENT SPECIFICATION

(11) **EP 0 956 376 B1**
(45) Date of publication and mention of the grant of the patent: **09.01.2002**
(21) Application number: 97906369.0
(22) Date of filing: 21.02.1997
(51) Int. Cl.: C23C 16/32, C23C 16/34, C30B 25/00, C30B 25/12, C30B 29/36, C30B 29/38

(54) **A SUSCEPTOR FOR A DEVICE FOR EPITAXIALLY GROWING OBJECTS AND SUCH A DEVICE**
SUSZEPTOR FÜR VORRICHTUNG ZUM EPITAKTISCHEM ZÜCHTEN VON OBJEKTEN UND SOLCHE VORRICHTUNG
SUSCEPTEUR POUR DISPOSITIF DE CROISSANCE EPITAXIALE D'OBJETS ET CE DISPOSITIF

(30) Priority: 26.02.1996 SE 9600705
(43) Date of publication of application: 17.11.1999
(73) Proprietor: ABB RESEARCH LTD., 8050 Zürich (CH)
(72) Inventor: KORDINA, Olle, Durham, NC 27713 (US); FORNELL, Jan-Olov, S-216 19 Malmö (SE); BERGE, Rune, S-226 47 Lund (SE); NILSSON, Roger, S-226 52 Lund (SE)
(74) Representative: Olsson, Jan
(86) International application number: SE9700290
(87) International publication number: WO9731133

(56) References cited:
- EP-A- 0 181 624
- EP-A- 0 269 439
- EP-A- 0 519 608
- WO-A-96/23913

## Description

### TECHNICAL FIELD OF THE INVENTION AND PRIOR ART

The present invention relates to a susceptor for a device for epitaxially growing objects of one of a) SiC, b) a Group 3B-nitride and c) alloys thereof on a substrate to be received in the susceptor, said susceptor having a channel adapted to receive said substrate and through which a source material for the growth is intended to be fed, the walls of the susceptor surrounding said channel being made of a material which may be heated by induction created by heating means intended to surround the susceptor, and a device for epitaxially growing such objects in accordance with the preamble of the appended independent device claim.

Accordingly, the invention is applicable to the growth of SiC, Group 3B-nitrides and all types of alloys thereof, but the common problem of growing such crystals of a high quality will now by way of a non-limitative example be further explained for SiC.

High temperatures are needed for obtaining a good ordered growth of SiC-crystals and different growth techniques are conceivable and are within the scope of the present invention, but the Chemical Vapour Deposition (CVD) is the most used one for growing epitaxial layers of SiC for in particular power device applications, so that this technique will hereinafter be discussed for illuminating the problem to be solved by the invention. In the Chemical Vapour Deposition case said source material for the growth is present in the form of precursor gases, normally silane and propane, and heating to temperatures in excess of 1 400°C is needed both to obtain decomposition by cracking of these Si- and C-containing precursor gases and to ensure that the atoms are deposited on the substrate surface in an ordered manner. High temperatures also mean problems with impurities coming out of different types of material, so that the selection of a suitable material withstanding the high temperature is crucial in order to prevent unwanted impurities to be incorporated in the layers of the SiC crystal grown. In order to prevent this it is common practise to coat the susceptor walls, which normally are made of graphite, with a SiC layer. Furthermore, a susceptor of the type described in the introduction is a so called hot-wall type susceptor, in which the walls surrounding a channel receiving the substrate are heated, through which a substantially uniform temperature may be achieved in the susceptor, thus with only small temperature gradients, which is favourable to the quality of the crystal grown on the substrate. Also at these temperatures a difference in temperature between different wall parts surrounding the channel in such a susceptor in the order of 15-20K will result in a remarkable difference of the crystalline quality of the object grown with respect to the case of temperature uniformity. A susceptor of this type also provides a higher temperature in the gas phase than that of a so called cold-wall susceptor, and by that the cracking efficiency and all chemical reactions are raised. This may cause a problem with depletion of the precursor gases, however, due to the geometry and the expansion of the gas when it is heated the velocity is very high, which will improve the uniformity of the grown layers. It is also known through the Swedish patent application No. 9500326-5 of the applicant to place a plate of SiC in the susceptor between the susceptor and the substrate to solve the problem that the SiC coating underneath the substrate will be etched or sublimed and deposited on the backside of the somewhat colder substrate, which will limit the lifetime of the susceptor.

A hot-wall type susceptor as described in said Swedish patent application ensures the growth of epitaxial layers of SiC with a very high crystalline quality to high thicknesses with low impurity incorporation and long carrier lifetimes. However, this type of prior art susceptor is also associated with some problems. One of those is the difficulty to produce a hot-wall susceptor with a channel surrounded by thick walls, and the production thereof is carried out by material removal from one blank by a milling operation, which however is difficult to carry out, especially for long susceptor tubes, or spark machining, which is delicate to use when said blank is made of graphite, which mostly is the case, for creating said channel. Furthermore, the parts of the susceptor which are thinner than other parts will be slightly hotter than these other parts, so that so called "hot spots" will be created there with a more severe etching there than on other parts of the susceptor, so that the SiC coating will there be removed after a certain operation time of the susceptor, for example after approximately 300 hours, which may cause a disturbance on the growing layers if these lie close to the exposed graphite or other material used for the walls of the susceptor and by that limit the lifetime of the susceptor to the point when this takes place.

### SUMMARY OF THE INVENTION

The object of the present invention is to provide a susceptor and a device of the type defined in the introduction, through which the problems mentioned above of the prior art hot-wall type susceptor may be solved.

This object is in accordance with the invention obtained by making the susceptor defined above of at least two separate susceptor wall pieces and providing it with means for securing said wall pieces of the susceptor to each other for forming the susceptor. The walls of the susceptor being made of graphite or tantalum. The split of the susceptor into at least two separate parts will make the machining of the susceptor a lot simpler, since it will be much easier to produce each such part separately and secure them to each other, for instance by screwing, than the prior art machining, which will make the manufacturing costs significantly reduced, especially if large amounts of these susceptors are produced. Another effect of the splitting of the susceptor in several parts is that the electrical resistance will be higher across the interface between two such parts than elsewhere in the walls of the susceptor, so that currents induced by said heating means cannot form the large loops formed in the prior art hot-wall susceptors, where these loops substantially follow the perimeter of the hot-wall susceptor, but these loops will instead have a tendency to stay in one and the same wall piece of the susceptor, so that thinner parts of the susceptor walls will not be as hot as in the prior art constructions, which will prevent etching due to so called hot-spots, so that the susceptor lifetime may be increased. These two advantages of the susceptor according to the invention will lower the costs for producing an object grown in a susceptor of this type considerably.

According to a preferred embodiment of the invention the susceptor is made of at least four separate susceptor wall pieces surrounding said channel, namely two lateral wall pieces, a top wall piece and a bottom wall piece. It has turned out that a susceptor so constructed may be manufactured very easily and accordingly to low costs, and the heat profiles of the different pieces may be efficiently controlled, so that a substantially uniform temperature may be obtained in substantially the whole susceptor reducing etching of surfaces thereof and by that prolonging the lifetime of the susceptor as well as improving the crystalline quality of the object grown in said susceptor.

According to another preferred embodiment of the invention said securing means comprises screws. Such a susceptor will be very easy to manufacture with a separate machining of the individual wall pieces of the susceptor and after that screwing them together. The securing means are preferably made of the same material as the wall of the susceptor, so that for susceptor walls of graphite and securing means in the form of screws graphite screws are used as securing means. This prevents the introduction of other materials in the susceptor, which may influence the growth negatively by releasing new types of impurities, which may be incorporated in the layers grown, or deteriorating the temperature uniformity of the region of the walls of the susceptor where the securing means are arranged.

According to another preferred embodiment of the invention each of said securing means extends through a lateral wall of the susceptor and the intervals forming the bottom and the top, respectively, of the susceptor channel for securing these walls to each other. Such a construction will make the assembly of the susceptor very simple with a minimum of securing means. "Securing means" is here to be interpreted very broadly and comprises for instance the case when a screw extends from a bottom wall through a lateral wall to a top wall, in which a nut or a threaded recess is arranged and the case when a screw extending from one of the bottom and the top wall into a lateral wall and a sleeve extend from the other of said walls into said lateral wall for attaching them to each other there and so on. Accordingly, the definition "securing means" is intended to comprise the combination of such members establishing in a rigid connection.

According to another preferred embodiment of the invention the susceptor has at least one wall piece forming one of a) the bottom wall and b) the top wall of said channel and separated from lateral walls of the susceptor and a plate made of one of a) SiC, b) an alloy of SiC and the material grown and c) the material grown is placed on said at least one wall piece for covering thereof and inserted between said lateral walls and said at least one wall piece. Thanks to this technique of applying a SiC-plate in a so called hot-wall susceptor the problems of a severe etching of the SiC-coating and the walls of the susceptor close to the edges of the SiC-plate in the prior art susceptors is totally eliminated thanks to the fact that no such edges of the SiC-plate is located within the channel of the susceptor any longer. This will of course further increase the lifetime of such a susceptor.

According to another preferred embodiment of the invention a first plate made of one of a) SiC, b) an alloy and the material grown and c) the material grown is placed on said bottom wall piece for covering thereof and inserted between said two lateral wall pieces and said bottom wall piece and a second plate made of one of a) SiC, b) an alloy of SiC and the material grown and c) the material grown is placed directly under said wall piece for covering thereof and inserted between said lateral wall pieces and said top wall piece. In such a susceptor both the top and the bottom of the susceptor will be efficiently protected against severe etching, so that the lifetime of the susceptor will be prolonged further.

According to another preferred embodiment of the invention the susceptor is provided with at least two channels adapted to receive at least one substrate for the growth of at least one said object each, each channel is delimited by two lateral wall pieces, a top wall piece and a bottom wall piece, and a wall piece separating two adjacent channels form a bottom wall piece for one channel and the top wall piece for the other channel. Such a susceptor has the advantages of a simple manufacture procedure and a prolonged lifetime mentioned above and in addition thereto the advantage of allowing a production of at least two crystals in the same growth run lowering the production costs thereof considerably.

According to still a further embodiment of the invention constituting a further development of the embodiment last discussed, said first and second plates are placed on said bottom wall pieces and directly under said top wall piece and inserted between two lateral wall pieces and the respective top and bottom wall piece of each channel in the susceptor. This leads to the advantages mentioned above in the case of such plates arranged in a susceptor with one channel also in a susceptor having at least two channels.

The advantages of the device according to the invention may easily be derived from the discussion above of the preferred embodiments of the inventional susceptor.

Further preferred features and advantages of the susceptor and the device according to the invention will appear from the following description and the other dependent claims.

### BRIEF DESCRIPTION OF THE DRAWINGS

With reference to the appended drawings, below follows a specific description of preferred embodiments of the invention cited as examples. In the drawings:
- Fig. 1: is a longitudinal cross-section view of a susceptor according to the prior art,
- Fig. 2: is an end view from the left of the susceptor according to Fig. 1,
- Fig. 3: is an end view from the right of the susceptor according to Fig. 1,
- Fig. 4: is a longitudinal cross-section view of a susceptor according to a first preferred embodiment of the invention,
- Fig. 5: is an end view from the right of the susceptor according to Fig. 4,
- Fig. 6: is an end view from the left of the susceptor according to Fig. 4,
- Fig. 7: is a longitudinal cross-section view of a susceptor according to a second preferred embodiment of the invention,
- Fig. 8: is an end view from the left of the susceptor according to Fig. 7, and
- Fig. 9: is an end view from the right of the susceptor according to Fig. 7.

### DESCRIPTION OF A PRIOR ART SUSCEPTOR AND DEVICE

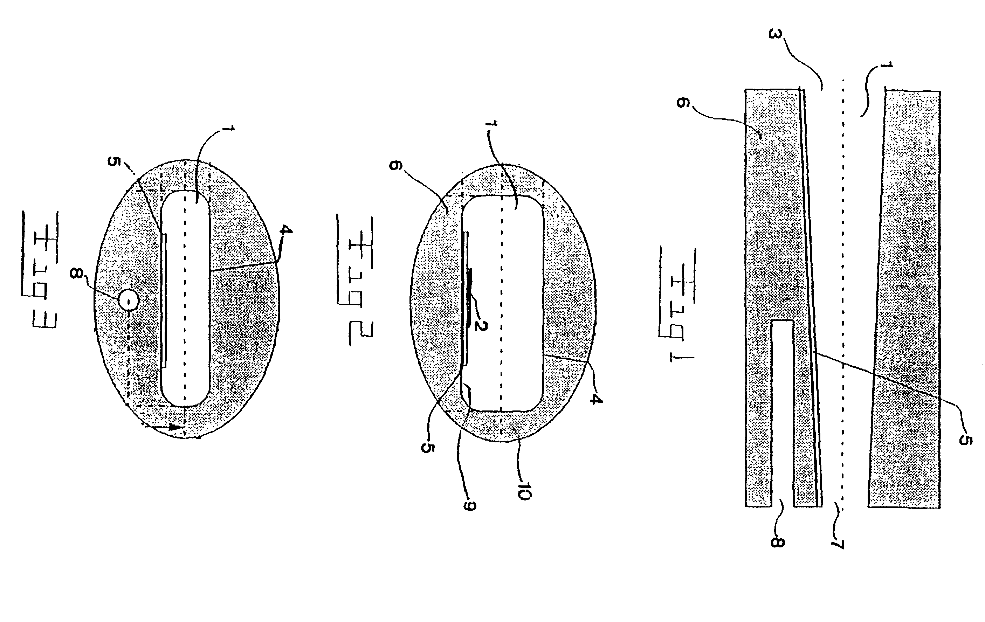

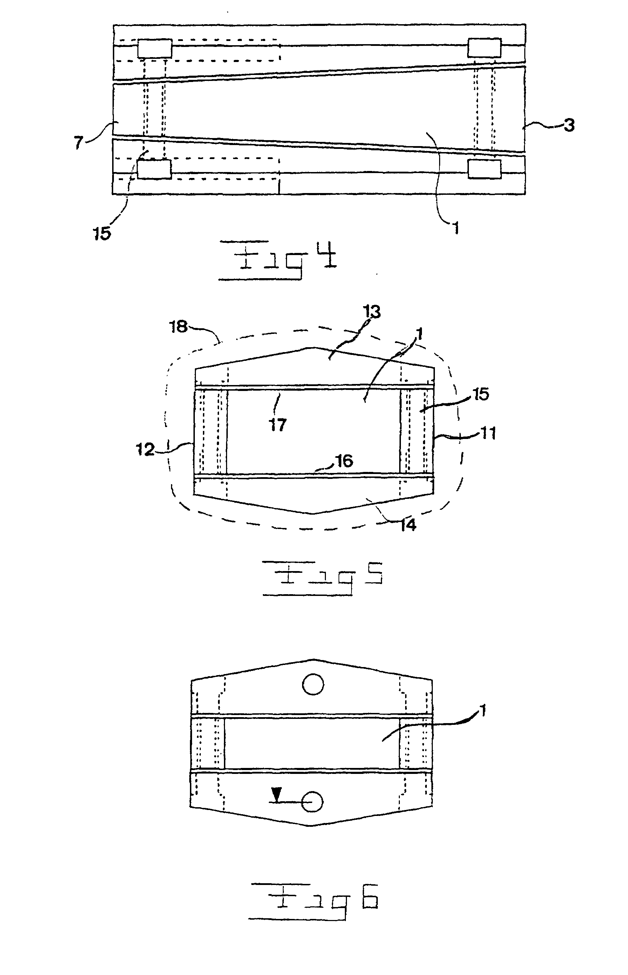

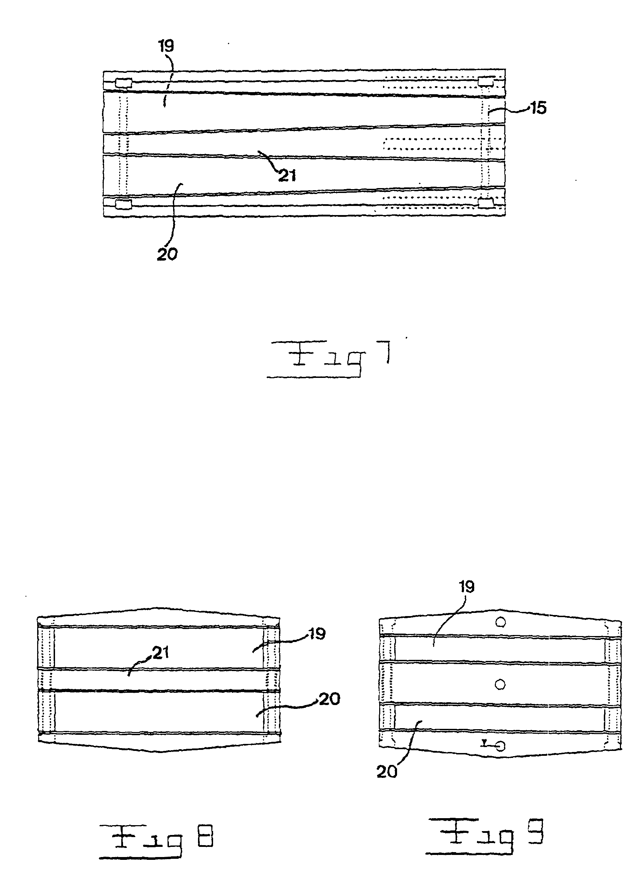

Fig. 1-3 show a susceptor according to the prior art and of the type described in the Swedish patent application 9500326-5 of the applicant, and this prior art susceptor may briefly be discussed for better understanding the invention. This susceptor is a so called hot-wall susceptor, i.e. the susceptor walls surrounding a channel 1 therein are to be heated for heating a substrate 2 received in the channel as well as precursor gases introduced into the larger opening 3 of the susceptor for epitaxially growing a SiC crystal on the substrate by Chemical Vapour Deposition. "Walls" is defined as comprising lateral walls as well as the bottom and the top wall pieces surrounding the channel. The susceptor is of graphite and coated by a thin SiC coating 4. A SiC-plate 5 of high crystalline quality is applied on the bottom surface of the channel 1 between the substrate 2 and the bottom part of the wall 6 of the susceptor for solving the problems of sublimation and etching of the SiC-coating 4 below the substrate 2 described in said Swedish patent application. The channel 1 tapers from the inlet opening 3 towards the outlet opening 7 for counteracting a depletion of the precursor gases, which normally are silane and propane, introduced through the opening 3 for said growth by increasing the velocity of these gases slightly deeper in the channel, which means that the stagnant gas layer to be penetrated for deposition on the substrate will be thinner and the growth rate will increase.

A susceptor of this type is used to grow films of a thickness of 20-50 m for the use in primarily high power semiconductor devices. The gas mixture is led through the channel 1 of the susceptor, said gas mixture containing a H₂ carrier gas and C- and Si-containing precursor gases, preferably in the form of propane and silane. Heating means not shown heats the susceptor walls 6 so that the substrate will obtain a temperature of 1500-1700°C, preferably about 1550°C, and the gas mixture introduced into the channel will be heated by dissipation of heat from the susceptor, which will result in a cracking of the precursor gases for formation of silicon and carbon-atoms, which will be deposited onto the surface of the SiC-substrate 2. In the figures it is also shown that the susceptor has a recess 8 for facilitating the handling of the susceptor during introduction into and removal out of the casing in which the growth takes place. It may also be mentioned that typical dimensions are for the channel a length of 100 mm and a width of 50 mm, the substrate a length and width of about 30 mm and a thickness of 0,3 mm and for the SiC-plate a thickness of approximately 1 mm. These typical dimensions are also valid for the susceptor according to the preferred embodiments of the invention described below.

This susceptor has however some disadvantages, one of which is the fact that the production thereof requires a delicate and time consuming machining of a blank of graphite, which makes the manufacturing costs thereof high. Another disadvantage is, as already mentioned, that there will be a severe etching of the SiC coating and graphite of the susceptor in the region 9 close to the edges of the SiC-plate 5. The etching is more severe at these places since the lateral walls 10 of the susceptor are thinner than the other walls of the susceptor and will thus be slightly hotter than said other walls.

### DETAILED DESCRIPTION OF PREFERRED EMBODIMENTS OF THE INVENTION

Figs. 4-6 show schematically a susceptor according to a preferred embodiment of the invention. This susceptor is also a so called hot-wall susceptor, which is formed by four separate wall pieces, namely two lateral wall pieces 11, 12, a top wall piece 13, and a bottom wall piece 14, preferably of graphite and covered by a thin SiC-coating, and these wall pieces are secured to each other by screws 15, preferably also of graphite, extending from the top wall piece 13 to the bottom wall piece 14 through a respective lateral wall piece 11 or 12. A first plate 16 made of SiC is placed on the bottom wall piece 14 for covering thereof and inserted between said two lateral wall pieces 11, 12 and the bottom wall piece 14, while a second plate 17 made of SiC is placed directly under the top wall piece for covering thereof and inserted between two lateral wall pieces 11, 12 and said top wall piece 13. The plates 16, 17 extend through the entire susceptor for separating the different wall pieces 11-14 from each other. It is evident that this susceptor will be easy to produce, since a production of the different wall pieces would be rather simple and it will then be easy to screw the wall pieces with the SiC-plates therebetween together.

It is indicated by a dashed line 18 in Fig. 5 how heating means may surround the susceptor so as to create induction currents therein. Said heating means 18 is preferably a Rf-field radiating coil. The loops of induction current created by the heating means has a tendency to substantially follow the perimeter of the susceptor in the normal case, but in the present invention the electrical resistance will be higher where the walls are divided, so that the current loop induced by said heating means will be kept within each wall piece for heating thereof. This means no severe etching due to so called hot spots, and the fact that the SiC-plates cover the entire bottom and ceiling of the susceptor channel 1 and that they are inserted between the bottom and top wall piece and the latter wall pieces means that the edges of the SiC-plates are hidden outside the susceptor channel, so that the problem of severe etching close thereto will be eliminated. Thus, the lifetime of the susceptor may be prolonged with respect to susceptors already known.

Fig. 7-9 illustrates schematically a susceptor according to a second preferred embodiment of the invention, which is formed by seven separate wall pieces screwed together by screws 15. This embodiment is also provided with SiC plates 16, 17 of the same type as the embodiment described above. The susceptor created in this way has two channels 19, 20 separated by a central wall piece 21 forming the bottom of the channel 19 and the top of the channel 20. This susceptor will have the same principle characteristics and advantages as the susceptor according to the first preferred embodiment of the invention and the additional advantage of the possibility to produce at least two crystals in one and the same growth run.

The invention is of course not in any way restricted to the preferred embodiment of the susceptor and the device described above, but several possibilities to modifications thereof would be apparent to a man skilled in the art without departing from the basic idea of the invention.

As already mentioned, the invention is also applicable to the growth of a Group 3B-nitride, an alloy of such Group 3B-nitrides or an alloy of SiC and one or more Group 3B-nitrides and will lead to the corresponding simplification and prolongation of the lifetime of the susceptor arid such a device in the case of growth of such objects.

The substrate may be of another material than SiC, such as Group 3B-nitrides.

Although it is shown in the figures and indicated in the description that the susceptor is substantially horizontally orientated, it is well possible to give the susceptor any other desired orientation in the room.

The definition "object" in the claims is made for including the epitaxial growth of all types of crystals, such as layers of different thicknesses as thick boules.

All definitions concerning the material of course also include inevitable impurities as well as intentional doping.

The securing means may of course be another than screws and corresponding threaded bores or nuts.

Furthermore, the susceptor has not to be of graphite, but for instance tantalum is also conceivable as material therefore. Preferably, the screws or other securing means are made of the same material as the susceptor walls, so as to avoid the introduction of new types of impurities and facilitating the heating of the walls and the obtention of the temperature uniformity thereof.

## Claims

1. A susceptor for a device for epitaxially growing objects of one of a) SiC, b) a Group 3B-nitride and c) alloys thereof on a substrate to be received in the susceptor, said susceptor having a channel (1, 19, 20) adapted to receive said substrate and through which a source material for the growth is intended to be fed, the walls (11-14, 21) of the susceptor surrounding said channel being made of graphite or tantalum which may be heated by induction created by heating means (18) intended to surround the susceptor, **characterized in that** the susceptor is made of at least two separate susceptor wall pieces (11-14, 21), and that it comprises means (15) for securing said wall pieces of the susceptor to each other for forming the susceptor.

2. A susceptor according to claim 1, **characterized in that** the susceptor is made of at least four separate susceptor wall pieces (11-14, 21) surrounding said channel (1, 19, 20), namely two lateral wall pieces (11, 12), a top wall piece (13) and a bottom wall piece (14).

3. A susceptor according to claim 1 or 2, **characterized in that** the securing means comprises screws (15).

4. A susceptor according to any of claims 1-3, **characterized in that** the securing means (15) are made of the same material as the walls (11-14, 21) of the susceptor.

5. A susceptor according to any of claims 1-4, **characterized in that** each of said securing means (15) extends through a lateral wall (11, 12) of the susceptor and into walls forming the bottom and the top, respectively, of the susceptor channel (1, 19, 20) for securing these walls to each other.

6. A susceptor according to any of claims 1-5, **characterized in that** said susceptor wall pieces (11-14, 21) are made of graphite.

7. A susceptor according to claim 6, **characterized in that** the susceptor wall pieces (11-14, 21) are coated by a protective SiC-layer (4).

8. A susceptor. according to any of claims 1-7, **characterized in that** the susceptor has at least one wall piece forming one of a) the bottom wall and b) the top wall of said channel (1, 19, 20) and separated from lateral walls (11, 12) of the susceptor and that a plate (16, 17) made of one of a) SiC, b) an alloy of SiC and the material grown and c) the material grown is placed on said at least one wall piece (13, 14) for covering thereof, and inserted between said lateral walls and said at least one wall piece.

9. A susceptor according to claim 2 or claim 2 and any of claims 3-8, **characterized in that** a first plate (16) made of one of a) SiC, b) an alloy of SiC and the material grown and c) the material grown is placed on said bottom wall piece (14) for covering thereof and inserted between said two lateral wall pieces (11, 12) and said bottom wall piece and a second plate (17) made of one of a) SiC, b) an alloy of SiC and the material grown and c) the material grown is placed directly under said top wall piece (13) for covering thereof and inserted between said two lateral wall pieces and said top wall piece.

10. A susceptor according to claim 2 or claim 2 and any of claims 3-9, **characterized in that** it is provided with at least two channels (19, 20) adapted to receive at least one substrate for the growth of at least one said object each, that each channel is delimited by two lateral wall pieces, a top wall piece and a bottom wall piece, and that a wall piece (21) separating two adjacent channels forms the bottom wall piece for one channel (19) and the top wall piece for the other channel (20).

11. A susceptor according to claims 9 and 10, **characterized in that** said first and second plates (16, 17) are placed on said bottom wall piece and directly under said top wall piece and inserted between two lateral wall pieces and the respective top and bottom wall piece of each channel (19, 20) in the susceptor.

12. A susceptor according to claims 8 or 9, **characterized in that** said plates (16, 17) are made of SiC.

13. A susceptor according to any of claims 1-12, **characterized in that** said channel (1, 19, 20) is adapted to receive a substrate on which an object of SiC is to be epitaxially grown.

14. A susceptor according to any of claims 1-13, **characterized in that** said susceptor wall pieces (11-14) are made of a material being well heatable by a Rf-field radiating means (18).

15. A device for epitaxially growing objects of one of a) SiC, b) a Group 3B-nitride and c) alloys thereof on a substrate comprising a susceptor according to claim 1 adapted to receive said substrate, said susceptor having a channel (1, 19, 20) adapted to receive said substrate and through which a source material for the growth is intended to be fed, and means (18) for heating the susceptor surrounding said channel and by that the substrate and said source material fed through the channel for the growth, **characterized in that** the susceptor is made of at least two separate susceptor wall pieces (11-14, 21) surrounding said channel, and that the susceptor comprises means (15) for securing said susceptor wall pieces to each other.

16. A device according to claim 15, **characterized in that** said susceptor is a susceptor according to any of claims 2-14.

## Patentansprüche

1. Suszeptor für eine Vorrichtung zum epitaktischen Aufwachsen von Objekten aus a) SiC, b) einem Nitrid der Gruppe 3B oder c) Legierungen derselben auf einem Substrat, das in dem Suszeptor aufgenommen ist, wobei der Suszeptor einen Kanal (1, 19, 20) aufweist, der derart ausgebildet ist, um das Substrat aufzunehmen, und
durch welchen ein Quellenmaterial für das Aufwachsen zugeführt wird, wobei die Wände (11 - 14, 21) des Suszeptors, die den Kanal umgeben, aus Graphit oder Tantal bestehen und durch Induktion erwärmt werden, die durch ein Heizmittel (18) erzeugt wird, welches den Suszeptor umgibt, **dadurch gekennzeichnet, daß** der Suszeptor aus zumindest zwei separaten Suszeptorwandstücken (11 - 14, 21) besteht, und **daß** dieser ein Mittel (15) umfaßt, um die Wandstücke des Suszeptors zur Bildung des Suszeptors aneinander zu befestigen.

2. Suszeptor nach Anspruch 1,
**dadurch gekennzeichnet, daß**
der Suszeptor aus zumindest vier separaten Suszeptorwandstücken (11 - 14, 21) besteht, die den Kanal (1, 19, 20) umgeben, nämlich zwei seitlichen Wandstücken (11, 12), einem oberen Wandstück (13) und einem unteren Wandstück (14).

3. Suszeptor nach Anspruch 1 oder 2,
**dadurch gekennzeichnet, daß**
das Befestigungsmittel Schrauben (15) umfaßt.

4. Suszeptor nach einem der Ansprüche 1-3,
**dadurch gekennzeichnet, daß**
das Befestigungsmittel (15) aus demselben Material wie die Wände (11 - 14, 21) des Suszeptors besteht.

5. Suszeptor nach einem der Ansprüche 1-4,
**dadurch gekennzeichnet, daß**
sich jedes der Befestigungsmittel (15) durch eine Seitenwand (11, 12) des Suszeptors und in Wände des Suszeptorkanales (1, 19, 20), die den unteren Bereich bzw. den oberen Bereich bilden, verläuft, um diese Wände aneinander zu befestigen.

6. Suszeptor nach einem der Ansprüche 1-5,
**dadurch gekennzeichnet, daß**
die Suszeptorwandstücke (11 - 14, 21) aus Graphit bestehen.

7. Suszeptor nach Anspruch 6,
**dadurch gekennzeichnet, daß**
die Suszeptorwandstücke (11 - 14, 21) mit einer schützenden SiC-Schicht (4) beschichtet sind.

8. Suszeptor nach einem der Ansprüche 1-7,
**dadurch gekennzeichnet, daß**
der Suszeptor zumindest ein Wandstück aufweist, das a) die untere Wand oder b) die obere Wand des Kanals (1, 19, 20) bildet: und von den Seitenwänden (11, 12) des Suszeptors getrennt ist, und **daß** eine Platte (16, 17) bestehend aus a) SiC, b) einer Legierung; aus SiC und dem aufgewachsenen Material oder c) dem aufgewachsenen Material auf dem zumindest einen Wandstück (13, 14) zur Abdekkung desselben angeordnet und zwischen die Seitenwände und das zumindest eine Wandstück eingesetzt ist.

9. Suszeptor nach Anspruch 2 oder Anspruch 2 und einem der Ansprüche 3-8,
**dadurch gekennzeichnet, daß**
eine erste Platte (16) bestehend aus a) SiC, b) einer Legierung aus SiC und dem aufgewachsenem Material oder c) dem aufgewachsenen Material auf dem unteren Wandstück (14) zur Abdeckung desselben angeordnet und zwischen die beiden seitlichen Wandstücke (11, 12) und das untere Wandstück eingesetzt ist, und **daß** eine zweite Platte (17) bestehend aus a) SiC, b) einer Legierung von SiC und dem aufgewachsenen Material oder c) dem aufgewachsenen Material direkt unter dem oberen Wandstück (13) zur Abdeckung desselben angeordnet und zwischen die beiden seitlichen Wandstücke und das obere Wandstück eingesetzt ist.

10. Suszeptor nach Anspruch 2 oder Anspruch 2 und einem der Ansprüche 3-9,
**dadurch gekennzeichnet, daß**
dieser mit zumindest zwei Kanälen (19, 20) versehen ist, die derart ausgebildet sind, um zumindest ein Substrat für das Aufwachsen zumindest jeweils eines Objektes aufzunehmen, daß jeder Kanal durch zwei seitliche Wandstücke, ein oberes Wandstück und ein unteres Wandstück begrenzt ist, und **daß** ein Wandstück (21), das zwei benachbarte Kanäle trennt, das untere Wandstück für einen Kanal (19) und das obere Wandstück für den anderen Kanal (20) bildet.

11. Suszeptor nach einem der Ansprüche 9 und 10,
**dadurch gekennzeichnet, daß**
die ersten und zweiten Platten (16, 17) auf dem unteren Wandstück und direkt unter dem oberen Wandstück angeordnet und zwischen zwei seitlichen Wandstücken und dem jeweiligen oberen und unteren Wandstück jedes Kanals (19, 20) in den Suszeptor eingesetzt sind.

12. Suszeptor nach einem der Ansprüche 8 oder 9,
**dadurch gekennzeichnet, daß**
die Platten (16, 17) aus SiC bestehen.

13. Suszeptor nach einem der Ansprüche 1-12,
**dadurch gekennzeichnet, daß**
**daß** der Kanal (1, 19, 20) derart ausgebildet ist, um ein Substrat aufnehmen zu können, auf welchem ein Objekt aus SiC epitaktisch aufgewachsen wird.

14. Suszeptor nach einem der Ansprüche 1-13,
**dadurch gekennzeichnet, daß**
die Suszeptorwandstücke (11 - 14) aus einem Material bestehen, das durch ein ein HF-Feld ausstrahlendes Mittel (18) gut aufheizbar ist.

15. Vorrichtung zum epitaktischen Aufwachsen von Objekten aus a) SiC, b) einem Nitrid der Gruppe 3B oder c) Legierungen derselben auf einem Substrat mit einem Suszeptor nach Anspruch 1, der derart ausgebildet ist, um das Substrat aufzunehmen, wobei der Suszeptor einen Kanal (1, 19, 20) aufweist, der derart ausgebildet ist, um das Substrat aufzunehmen, und durch welchen ein Quellenmaterial für das Aufwachsen eingeführt wird, und einem Mittel (18) zum Aufheizen des Suszeptors, der den Kanal umgibt, und dadurch des Substrates und des Quellenmaterials, das durch den Kanal zum Aufwachsen zugeführt wird, **dadurch gekennzeichnet, daß** der Suszeptor aus zumindest zwei separaten Suszeptorwandstücken (11 - 14, 21) besteht, die den Kanal umgeben, und **daß** der Suszeptor ein Mittel (15) umfaßt, um die Suszeptorwandstücke aneinander zu befestigen.

16. Vorrichtung nach Anspruch 15,
**dadurch gekennzeichnet, daß**
der Suszeptor ein Suszeptor nach einem der Ansprüche 2 - 14 ist.

## Revendications

1. Suscepteur pour un dispositif pour faire croître par épitaxie des objets en l'un parmi le a) SiC, b) un nitrure du groupe 3B et c) leurs alliages sur un substrat destiné à être reçu dans le suscepteur, le suscepteur comportant un canal (1, 19, 20) conçu pour recevoir le substrat et par lequel un matériau source pour la croissance est destiné à être envoyé, les parois (11-14, 21) du suscepteur entourant le canal étant en graphite ou en tantale qui peut être chauffé par induction créé par des moyens de chauffage (18) destinés à entourer le suscepteur, **caractérisé en ce que** le suscepteur est réalisé à partir d'au moins deux parties (11-14, 21) de parois de suscepteur distinctes et **en ce qu'**il comporte des moyens (15) destinés à fixer des parties de parois du suscepteur l'une à l'autre pour former le suscepteur.

2. Suscepteur suivant la revendication 1, **caractérisé en ce que** le suscepteur est réalisé à partir d'au moins quatre parties (11-14, 21) de parois de suscepteur distinctes entourant le canal (1, 19, 20), à savoir deux parties (11, 12) de parois latérales, une partie (13) de paroi supérieure et une partie (14) de paroi de fond.

3. Suscepteur suivant la revendication 1 ou 2, **caractérisé en ce que** les moyens de fixation comportent des vis (15).

4. Suscepteur suivant l'une quelconque des revendications 1 à 3, **caractérisé en ce que** les moyens (15) de fixation sont réalisés en le même matériau que celui des parois (11-14, 21) du suscepteur.

5. Suscepteur suivant l'une quelconque des revendications 1 à 4, **caractérisé en ce que** chacun des moyens (15) de fixation s'étend à travers une paroi (11, 12) latérale du suscepteur et dans des parois formant le fond et le dessus respectivement du canal (1, 19, 20) du suscepteur pour fixer ces parois les unes aux autres.

6. Suscepteur suivant l'une quelconque des revendications 1 à 5, **caractérisé en ce que** les parties (11-14, 21) de parois de suscepteur sont en graphite.

7. Suscepteur suivant la revendication 6, **caractérisé en ce que** les parties (11-14, 21) de parois de suscepteur sont revêtues d'une couche (4) en SiC protectrice.

8. Suscepteur suivant l'une quelconque des revendications 1 à 7, **caractérisé en ce que** le suscepteur comporte au moins une partie de paroi formant l'une de a) la paroi de fond et b) la paroi supérieure du cainal (1, 19, 20) et distincte des parois (11, 12) latérales du suscepteur et **en ce qu'**une plaque (16, 17) réalisée en l'un de a) SiC, b) un alliage de SiC et du matériau que l'on a fait croître et c) le matériau que l'on a fait croître, est placée sur ladite au moins une partie (13, 14) de paroi pour la recouvrir et est insérée entre les parois latérales et ladite au moins une partie de paroi.

9. Suscepteur suivant la revendication 2 ou suivant la revendication 2 et l'une quelconque des revendications 3 à 8, **caractérisé en ce qu'**une première plaque (16) réalisée en l'un parmi a) le SiC, b) un alliage de SiC et du matériau que l'on a fait croître et c) le matériau que l'on a fait croître, est placée sur la partie (14) de paroi de fond pour la recouvrir et est insérée entre deux parties (11, 12) de parois latérales et la partie de paroi de fond et une seconde plaque (17) réalisée en l'un parmi a) le SiC, b) un alliage de SiC et du matériau que l'on a fait croître et c) le matériau que l'on a fait croître, est placée directement sous la partie (13) de paroi supérieure pour la recouvrir et est insérée entre lesdites deux parties de parois latérales et la partie de paroi supérieure.

10. Suscepteur suivant la revendication 2 ou suivant la revendication 2 et l'une quelconque des revendications 3 à 9, **caractérisé en ce qu'**il est muni d'au moins deux canaux (19, 20) conçus pour recevoir au moins un substrat pour la croissance d'au moins un objet chacun, **en ce que** chaque canal est délimité par deux parties de parois latérales, une partie de paroi supérieure et une partie de paroi de fond, et **en ce qu'**une partie (21) de paroi séparant deux canaux adjacents forment la partie de paroi de fond pour un canal (19) et la partie de paroi supérieure pour l'autre canal (20).

11. Suscepteur suivant les revendications 9 et 10, **caractérisé en ce que** les première et seconde plaques (16, 17) sont placées sur la partie de paroi de fond et directement sous la partie de paroi supérieure et sont insérées entre deux parties de parois latérales et la partie de paroi supérieure et de fond respective de chaque canal (19, 20) dans le suscepteur.

12. Suscepteur suivant la revendication 8 ou 9, **caractérisé en ce que** les plaques (16, 17) sont en SiC.

13. Suscepteur suivant l'une quelconque des revendications 1 à 12, **caractérisé en ce que** le canal (1, 19, 20) est conçu pour recevoir un substrat sur lequel on fait croître epitaxialement un objet en SiC.

14. Suscepteur suivant l'une quelconque des revendications 1 à 13, **caractérisé en ce que** les parties (11-14) de parois de suscepteur sont en matériau qui peut être chauffé facilement par des moyens, (18) de rayonnement de champ Rf ou Hf.

15. Dispositif pour faire croître par épitaxie des objets en l'un de a) SiC, b) un nitrure du groupe 3B et c) leurs alliages sur un substrat, comportant un suscepteur suivant la revendication 1 conçu pour recevoir le substrat, le suscepteur ayant un canal (1, 19, 20) conçu pour recevoir le substrat et par lequel un matériau source pour la croissance est destiné à être envoyé, et des moyens (18) destinés à chauffer le suscepteur autour du canal et par cela le substrat et le matériau source envoyé par le canal pour la croissance, **caractérisé en ce que** le suscepteur est réalisé en au moins deux parties (11-14, 21) de parois de suscepteur distinctes entourant le canal, et **en ce que** le suscepteur comporte des moyens (15) destinés à fixer les parties de parois de suscepteur les unes aux autres.

16. Dispositif suivant la revendication 15, **caractérisé en ce que** le suscepteur est un suscepteur suivant l'une quelconque des revendications 2 à 14.
